# EUROPEAN PATENT APPLICATION

(11) **EP 4 632 703 A1**
(43) Date of publication of application: **15.10.2025**
(21) Application number: 25166275.5
(22) Date of filing: 26.03.2025
(51) Int. Cl.: G07D 7/04

(54) **MAGNETIC LINE SENSOR, SHEET RECOGNITION UNIT, AND SHEET HANDLING DEVICE**

(30) Priority: 29.03.2024 JP 2024056693
(71) Applicant: GLORY LTD., Himeji-shi Hyogo 670-8567 (JP)
(72) Inventor: SENGOKU, Tomoyuki, Hyogo, 670-8567 (JP); YOKOIE, Daiki, Hyogo, 670-8567 (JP); CHIKAMORI, Masafumi, Hyogo, 670-8567 (JP); WAKABAYASHI, Shunki, Hyogo, 670-8567 (JP)
(74) Representative: SSM Sandmair

(57) **Abstract**

Provided are a magnetic line sensor capable of inexpensively suppressing noise due to vibrations from outside the magnetic line sensor, a sheet recognition unit, and a sheet handling device. The magnetic line sensor is in a multi-channel system and detects magnetic information of a transported sheet. The magnetic line sensor includes multiple magnetic sensor elements each provided for a corresponding channel and arranged in a main scanning direction, multiple chip ceramic capacitors each electrically connected to a corresponding one of the multiple magnetic sensor elements and each having a pair of external electrodes, and a substrate on which the chip ceramic capacitors are mounted. At least one of the chip ceramic capacitors has its pair of external electrodes aligned in a direction orthogonal to the main scanning direction.

## Description

### TECHNICAL FIELD

The present disclosure relates to magnetic line sensors, sheet recognition units, and sheet handling devices.

### BACKGROUND ART

Sheet recognition units which recognize sheets such as banknotes acquire the sheet features using various multi-channel sensors including an optical line sensor, a magnetic line sensor, and a thickness detection sensor. The sheet recognition units then typically recognize (determine) the type (denomination), authenticity, fitness, and other properties of the sheets based on the acquired sheet features.

A multi-channel magnetic line sensor usually includes multiple magnetic sensor elements arranged in the main scanning direction and processing circuits which process output signals from each magnetic sensor element. Many passive elements such as chip ceramic capacitors are used for the processing circuits.

JP 2016-012722 A discloses a surface mountable relatively low noise multilayer ceramic capacitor (MLCC) capacitor assembly.

### SUMMARY

Conventional multi-channel magnetic line sensors include multiple magnetic sensor elements for each channel and add up the outputs of the magnetic sensor elements to obtain the output signal of each channel.

The number of magnetic sensor elements arrangeable in the main scanning direction of such a magnetic line sensor is limited, which makes it difficult to increase the resolution of the magnetic line sensor in the main scanning direction.

Meanwhile, a system is possible that includes one magnetic sensor element for a corresponding channel to use the output of the magnetic sensor element as is as the output signal of the channel. This system can include more channels, thus achieving a correspondingly higher resolution in the main scanning direction.

This system, however, was found to have a small output of the magnetic sensor element of each channel, raising a new issue of noise which did not emerge in conventional multi-channel magnetic line sensors.

Specifically, noise may possibly be generated in the output signals of the magnetic line sensor when a medium enters the thickness detection sensor and when the medium leaves the thickness detection sensor. The present inventors investigated the cause of the noise in detail and found that the vibrations of the thickness detection sensor seem to be transmitted to the magnetic line sensor to cause the substrate of the magnetic line sensor to vibrate, resulting in a piezoelectric effect on the chip ceramic capacitors mounted on the substrate. This seemingly causes the noise.

JP 2016-012722 A describes a technique of reducing noise by employing a configuration that reduces contact between the multilayer ceramic capacitors and the substrate to reduce vibrations transmitted to the multilayer ceramic capacitors. However, implementing such measures against noise on the capacitors themselves, which are required in a large number, would increase the costs for the magnetic line sensor.

In response to the above current state of the art, an object of the present disclosure is to provide a magnetic line sensor capable of inexpensively suppressing noise due to vibrations from outside the magnetic line sensor, a sheet recognition unit, and a sheet handling device.

In order to solve the above issue and to achieve the object, (1) a first aspect of the present disclosure is directed to a magnetic line sensor that is in a multi-channel system and detects magnetic information of a transported sheet, the magnetic line sensor including multiple magnetic sensor elements each provided for a corresponding channel and arranged in a main scanning direction, multiple chip ceramic capacitors each electrically connected to a corresponding one of the multiple magnetic sensor elements and each having a pair of external electrodes, and a substrate on which the chip ceramic capacitors are mounted, at least one of the chip ceramic capacitors having its pair of external electrodes aligned in a direction orthogonal to the main scanning direction.

(2) In the magnetic line sensor according to (1) above, a longitudinal direction of the substrate may be oriented in the main scanning direction.

(3) The magnetic line sensor according to (1) or (2) above may further include multiple first amplifier circuits each electrically connected to a corresponding one of the multiple magnetic sensor elements and each being configured to amplify an output signal of the corresponding magnetic sensor element, and multiple second amplifier circuits each electrically connected to a corresponding one of the multiple first amplifier circuits via corresponding one or more of the multiple chip ceramic capacitors and each being configured to amplify an output signal of the corresponding first amplifier circuit.

(4) The magnetic line sensor according to any of (1) to (3) above may further include a frame to which the substrate is attached with a fixing member, wherein the substrate may have a through hole in which the fixing member is inserted, and a chip ceramic capacitor closest to the through hole among the multiple chip ceramic capacitors may have its pair of external electrodes aligned in a direction orthogonal to the main scanning direction.

(5) In the magnetic line sensor according to any of (1) to (4) above, all the chip ceramic capacitors may have their pair of external electrodes aligned in a direction orthogonal to the main scanning direction.

(6) A second aspect of the present disclosure is directed to a sheet recognition unit including the magnetic line sensor according to any of (1) to (5) above and a thickness detection sensor adjacent to the magnetic line sensor.

(7) A third aspect of the present disclosure is directed to a sheet handling device including the sheet recognition unit according to (6) above.

The present disclosure can provide a magnetic line sensor capable of inexpensively suppressing noise due to vibrations from outside the magnetic line sensor, a sheet recognition unit, and a sheet handling device.

### BRIEF DESCRIPTION OF DRAWINGS

FIG. 1 is a schematic perspective view of an example of a magnetic line sensor according to Embodiment 1.
FIG. 2 is a schematic perspective view of an example of a chip ceramic capacitor according to Embodiment 1.
FIG. 3 is a schematic plan view of an example of a substrate according to Embodiment 1.
FIG. 4 is a schematic view illustrating the principle of noise suppression in the magnetic line sensor according to Embodiment 1.
FIG. 5 is a circuit block diagram of an example of an electrical circuit in the magnetic line sensor according to Embodiment 1.
FIG. 6 includes: (a) a schematic cross-sectional view of the configuration of a sheet recognition unit according to Embodiment 1; and (b) a schematic plan view of the configuration of the sheet recognition unit according to Embodiment 1.
FIG. 7 includes: (a) a perspective view of the appearance of a sheet handling device according to Embodiment 2; and (b) a cross-sectional view of the internal structure of the sheet handling device according to Embodiment 2.
FIG. 8 includes: (a) a schematic cross-sectional view of the configuration of a sheet recognition unit according to Embodiment 2; and (b) a schematic plan view of the configuration of the sheet recognition unit according to Embodiment 2.
FIG. 9 is an exploded schematic perspective view of an example of a magnetic line sensor according to Embodiment 2.
FIG. 10 is a schematic plan view of an example of an amplifier substrate according to Embodiment 2.
FIG. 11 is a circuit diagram of the first half of an example of an electrical circuit of the amplifier substrate according to Embodiment 2.
FIG. 12 is a circuit diagram of the second half of the example of the electrical circuit of the amplifier substrate according to Embodiment 2.
FIG. 13 shows an example of the measurement result of an output waveform of a magnetic line sensor according to Comparative Embodiment 1.
FIG. 14 shows an example of the measurement result of an output waveform of the magnetic line sensor according to Embodiment 2.

### DESCRIPTION OF EMBODIMENTS

Hereinafter, embodiments of the magnetic line sensor, sheet recognition unit, and sheet handling device according to the present disclosure are described in detail with reference to the drawings. Various sheets such as banknotes, checks, vouchers, bills, business forms, documents of value, and card-like media are applicable as sheets used in the present disclosure. In the following, the present disclosure is described with devices and methods for banknotes taken as examples. The following description is about an example of the magnetic line sensor, an example of the sheet recognition unit, and an example of the sheet handling device.

The configurations having the same or similar functions in the following description are commonly assigned with the same reference sign throughout the embodiments and the drawings as appropriate, and description thereof is omitted as appropriate. Drawings showing a structure appropriately include the XYZ coordinate system where the XYZ axes are orthogonal to one another. The X-axis direction, the Y-axis direction, and the Z-axis direction respectively correspond to the sub-scanning direction, the main scanning direction, and the height direction (depth direction) of a line sensor, e.g., a magnetic line sensor.

### (Embodiment 1)

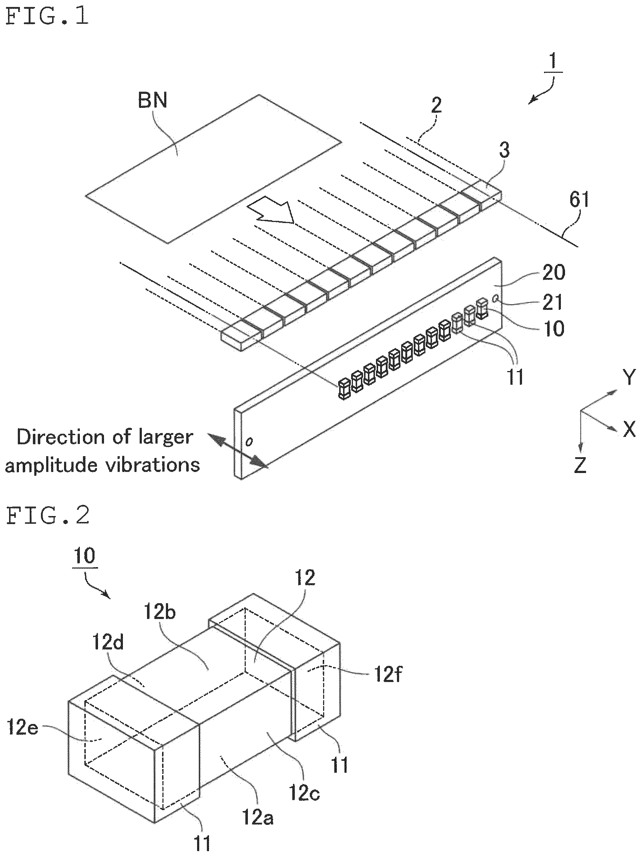

First, a magnetic line sensor according to Embodiment 1 is described. FIG. 1 is a schematic perspective view of an example of the magnetic line sensor according to Embodiment 1.

FIG. 1 shows the magnetic line sensor upside down for visibility, but the orientation of the magnetic line sensor according to the present disclosure is not limited and can be set as appropriate.

As shown in FIG. 1, a magnetic line sensor 1 according to the present embodiment is a multi-channel magnetic line sensor that detects the magnetic information of a transported banknote BN. The magnetic line sensor 1 may detect the magnetic information of the transported banknote BN in each of multiple detection regions 2 equally divided in the main scanning direction Y of the magnetic line sensor 1. The same number of the detection regions 2 as the number of channels of the magnetic line sensor 1 may be provided across from one side to the other side of a transport path 61 of a sheet recognition unit along which banknotes BN are transported.

Banknotes BN to be detected may be transported along the transport path 61 in the sub-scanning direction X of the magnetic line sensor 1 within the XY plane.

The magnetic line sensor 1 includes multiple magnetic sensor elements 3, multiple chip ceramic capacitors 10, and a substrate 20. Hereinafter, a chip ceramic capacitor may be abbreviated to simply "capacitor" in some cases.

The magnetic sensor elements 3 are each provided for a corresponding one of the channels. In other words, the number of output channels of the magnetic line sensor 1 is in a one-to-one relationship with the number of the magnetic sensor elements 3. This can increase the resolution in the main scanning direction Y. For example, the resolution in the main scanning direction Y can be three times that of a system in which three magnetic sensor elements are provided for a corresponding channel.

The multiple magnetic sensor elements 3 are arranged in the main scanning direction Y. The multiple magnetic sensor elements 3 may be arranged in a straight line as shown in FIG. 1. Yet, the multiple magnetic sensor elements 3 are not necessarily arranged in a strict straight line in the main scanning direction Y and may be slightly shifted in the sub-scanning direction X as long as they are arranged along an axis parallel to the main scanning direction Y.

The type of each magnetic sensor element 3 is not limited. Examples thereof include magnetic detection elements that output a change in magnetic flux density of a magnetic body as a voltage fluctuation. Examples of the magnetic detection elements include magnetoresistive elements (MR elements). Each magnetic sensor element 3 may output the magnitude (absolute value) of the magnetic flux density of a magnetic body, and may be, for example, a Hall element. The type of the magnetoresistive element (MR element) may be an anisotropic magnetoresistive element (AMR element), a giant magnetoresistive element (GMR element), or a tunnel magnetoresistive element (TMR element), for example.

Each magnetic sensor element 3 may be a difference output type that detects the edge of a magnetic body or a level output type that detects the entire region of a magnetic body.

The multiple chip ceramic capacitors 10 are each electrically connected to a corresponding one of the multiple magnetic sensor elements 3. One capacitor 10 may be provided for a corresponding magnetic sensor element 3. In other words, the number of capacitors 10 may be in a one-to-one relationship with the number of magnetic sensor elements 3.

The multiple capacitors 10 may be arranged in the main scanning direction Y, and may be arranged in a straight line as shown in FIG. 1. However, the positions of the capacitors 10 are not limited and can be set as appropriate.

Each chip ceramic capacitor 10 may be a surface-mount type multilayer ceramic capacitor. Furthermore, each capacitor 10 may function as a capacitor for a filter such as a high-pass filter.

FIG. 2 is a schematic perspective view of an example of a chip ceramic capacitor according to Embodiment 1.

As shown in FIG. 2, each chip ceramic capacitor 10 has a pair of external electrodes 11. Each capacitor 10 may have a ceramic body 12 having a substantially rectangular parallelepiped outer shape. The ceramic body 12 may have a first main face 12a and a second main face 12b facing each other in the height direction, a first side face 12c and a second side face 12d facing each other in the width direction, and a first end face 12e and a second end face 12f facing each other in the length direction. Each capacitor 10 may be mounted on the substrate 20 such that the first main face 12a faces the substrate 20. In other words, the first main face 12a of each capacitor 10 may be the mounting surface.

The pair of external electrodes 11 may be provided at opposing positions in the length direction of the capacitor 10, and may respectively be provided on the first end face 12e and the second end face 12f of the ceramic body 12. Each external electrode 11 may be provided from the first end face 12e or the second end face 12f to a portion of each of the first main face 12a, the second main face 12b, the first side face 12c, and the second side face 12d. In addition, each external electrode 11 may be electrically connected to internal electrodes (not shown) exposed from the ceramic body 12 at the first end face 12e or the second end face 12f.

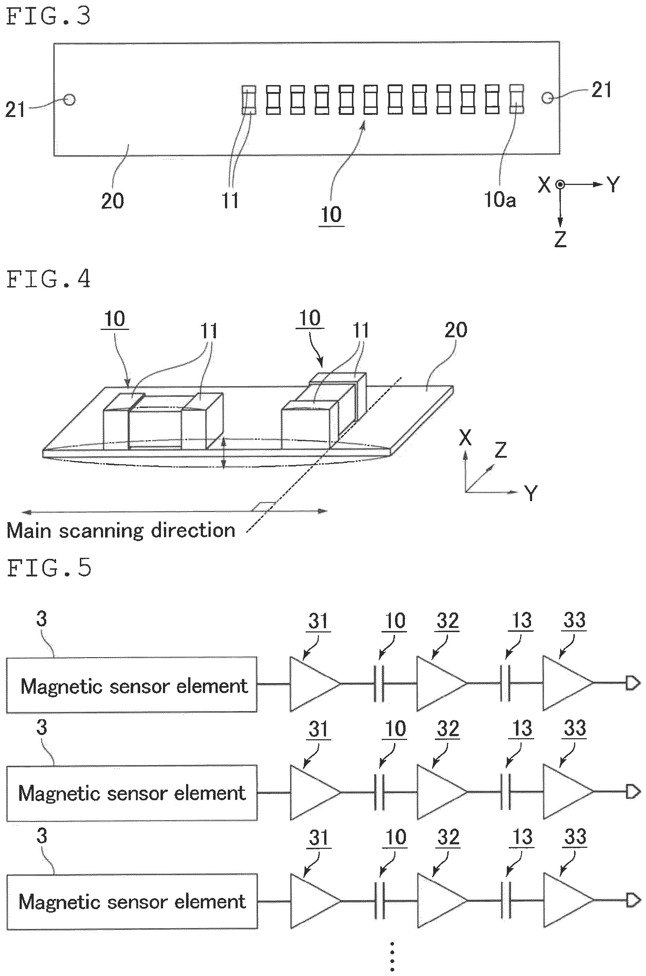

FIG. 3 is a schematic plan view of an example of a substrate according to Embodiment 1.

As shown in FIG. 3, the multiple chip ceramic capacitors 10 are mounted on the substrate 20. For example, the pair of external electrodes 11 of each capacitor 10 may be electrically and mechanically connected to a pair of pads (not shown) provided on the substrate 20 by a connecting member such as solder.

The substrate 20 may be an amplifier substrate that amplifies output signals of the magnetic sensor elements 3, and may include amplifier circuits connected to the respective magnetic sensor elements 3.

As shown in FIG. 1 and FIG. 3, at least one of the multiple chip ceramic capacitors 10 has its pair of external electrodes 11 aligned in a direction orthogonal to the main scanning direction Y. This can suppress the generation of vibration-induced noise in output signals of a channel corresponding to the magnetic sensor element 3 connected to the capacitor 10 arranged as above even when vibrations are transmitted from the outside to the magnetic line sensor 1. The reason for this is illustrated with reference to FIG. 4.

FIG. 4 is a schematic view illustrating the principle of noise suppression in the magnetic line sensor according to Embodiment 1.

The investigations by the present inventors revealed that the vibrations generated when a banknote enters the thickness detection sensor and when the banknote leaves the thickness detection sensor are greatest in the sub-scanning direction X of the magnetic line sensor 1. Thus, as shown on the left side of FIG. 4, if a chip ceramic capacitor 10 had its pair of external electrodes 11 aligned in a direction parallel to the main scanning direction Y, a large vibration in the sub-scanning direction X of the substrate 20 would cause the capacitor 10 to vibrate as well, likely deflecting the capacitor 10 between the pair of external electrodes 11. In other words, the piezoelectric effect is likely to occur in the capacitor 10.

In contrast, as shown on the right side of FIG. 4, with the chip ceramic capacitor 10 having its pair of external electrodes 11 aligned in a direction orthogonal to the main scanning direction Y, the capacitor 10 is less likely to vibrate even when the substrate 20 vibrates significantly in the sub-scanning direction X, so that the capacitor 10 is hardly deflected between the pair of external electrodes 11. In other words, the piezoelectric effect is less likely to occur in the capacitor 10. This can suppress the generation of noise due to vibrations from the outside in output signals of the channel corresponding to the magnetic sensor element 3 connected to the capacitor 10.

This measure against noise requires no special chip ceramic capacitors such as capacitors for suppressing acoustic noise, and can be achieved simply by changing the arrangement direction of the capacitors 10, which can thus be achieved inexpensively.

Hereinafter, a chip ceramic capacitor having its pair of external electrodes aligned in a direction orthogonal to the main scanning direction may be described as an orthogonally arranged capacitor, and arranging a chip ceramic capacitor such that the capacitor has its pair of external electrodes aligned in a direction orthogonal to the main scanning direction may be described as orthogonally arranging a capacitor or the like expression.

The longitudinal direction of the substrate 20 may be oriented in the main scanning direction Y as shown in FIG. 1 and FIG. 3. In this case, the substrate 20 vibrates more significantly in the sub-scanning direction X due to vibrations generated when a medium enters the thickness detection sensor and when the medium leaves the thickness detection sensor. However, even in such a case, since at least one capacitor 10 is orthogonally arranged in the present embodiment, the generation of noise due to the vibrations in outputs of the corresponding channel can be very effectively suppressed.

The longitudinal direction of the substrate means the long edge direction of the substrate.

The planar shape of the substrate 20 may be rectangular, and the long and short sides thereof may respectively extend in the main scanning direction Y and the height direction Z. The planar shape of the substrate 20 may be a partially notched shape.

As shown in FIG. 1 and FIG. 3, the substrate 20 may have multiple screw holes 21 as through holes in which screws are inserted as fixing members, and may be attached to the frame (not shown) of the magnetic line sensor 1 by screws (not shown). In other words, the substrate 20 may be fixed to the frame via the substrate 20 by fastening screws. The screw holes 21 may be provided in one end and the other end of the substrate 20 in the longitudinal direction of the substrate 20.

Any of the multiple chip ceramic capacitors 10 may be orthogonally arranged without limitation, and the capacitor(s) to be orthogonally arranged can be selected as appropriate. For example, as shown in FIG. 3, a capacitor 10a closest to any one of the screw holes 21 among the multiple capacitors 10 may be orthogonally arranged. Even with only the capacitor 10a closest to a screw hole 21 orthogonally arranged, a configuration capable of suppressing the generation of noise due to vibrations from the outside has been found to be achieved.

Of course, as shown in FIG. 3, all of the multiple chip ceramic capacitors 10 may be orthogonally arranged. This can more effectively suppress the generation of noise due to vibrations from the outside.

The fixing members and through holes are not limited to the screws and screw holes mentioned above. Any of various fixing members and through holes corresponding to the selected fixing members can be used.

FIG. 5 is a circuit block diagram of an example of an electrical circuit in the magnetic line sensor according to Embodiment 1.

As shown in FIG. 5, the magnetic line sensor 1 may include multiple first amplifier circuits 31 and multiple second amplifier circuits 32.

The multiple first amplifier circuits 31 are each electrically connected to a corresponding one of the multiple magnetic sensor elements 3 and are each configured to amplify an output signal of the corresponding magnetic sensor element 3. In other words, a first amplifier circuit 31 is provided for a corresponding magnetic sensor element 3, and each first amplifier circuit 31 amplifies output signals of the magnetic sensor element 3 connected thereto.

The multiple second amplifier circuits 32 are each electrically connected to a corresponding one of the multiple first amplifier circuits 31 via corresponding one or more of the multiple chip ceramic capacitors 10 and are each configured to amplify an output signal of the corresponding first amplifier circuit 31. In other words, a second amplifier circuit 32 is provided for a corresponding first amplifier circuit 31, and each second amplifier circuit 32 amplifies output signals of the first amplifier circuit 31 connected thereto.

Orthogonally arranging the chip ceramic capacitor 10 connected between the amplifier circuit 31 and the amplifier circuit 32, which respectively correspond to the first-stage and subsequent-stage amplifier circuits, as above can more effectively suppress noise due to vibrations from the outside.

In the magnetic line sensor 1, as shown in FIG. 5, a third amplifier circuit 33 may be connected as a further subsequent stage to the second amplifier circuit 32 via a chip ceramic capacitor 13. In other words, the magnetic line sensor 1 may include multiple third amplifier circuits 33, each of which is electrically connected to a corresponding one of the multiple second amplifier circuits 32 via corresponding one or more of multiple chip ceramic capacitors 13.

Each of the multiple chip ceramic capacitors 13 may or may not be orthogonally arranged. For example, at least one of the multiple chip ceramic capacitors 13 may be arranged such that the capacitor has its pair of external electrodes aligned in a direction parallel to the main scanning direction.

Each of the first amplifier circuits 31, the second amplifier circuits 32, and the third amplifier circuits 33 may include an operational amplifier (not shown).

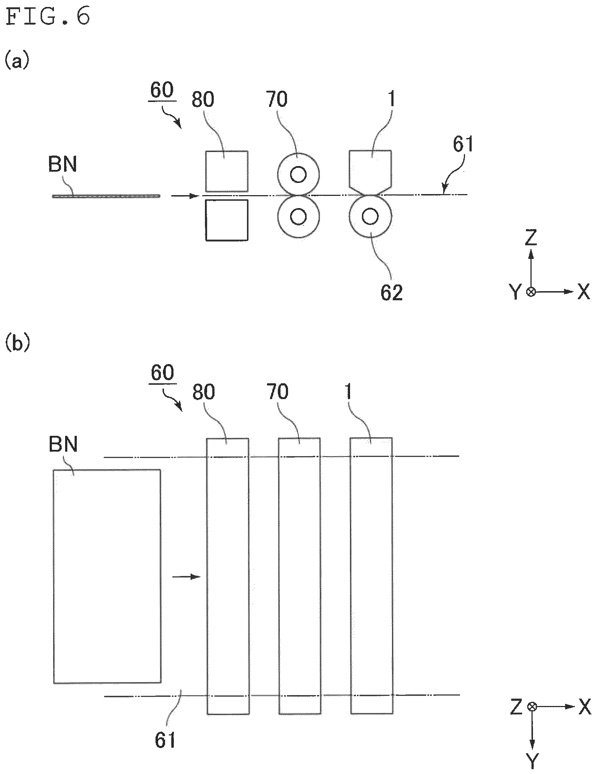

Next, a sheet recognition unit according to Embodiment 1 will be described. FIG. 6 includes: (a) a schematic cross-sectional view of the configuration of a sheet recognition unit according to Embodiment 1; and (b) a schematic plan view of the configuration of the sheet recognition unit according to Embodiment 1.

As shown in the views (a) and (b) of FIG. 6, a sheet recognition unit 60 according to Embodiment 1 includes the magnetic line sensor 1 and a thickness detection sensor 70 adjacent to the magnetic line sensor 1. In this case, vibrations generated when a banknote BN enters the thickness detection sensor 70 and when the banknote BN leaves the thickness detection sensor 70 are very easily transmitted to the magnetic line sensor 1, causing the substrate of the magnetic line sensor 1 to vibrate more significantly in the sub-scanning direction X. However, even in such a case, since at least one chip ceramic capacitor of the magnetic line sensor 1 is orthogonally arranged, the generation of noise due to the vibrations in outputs of the corresponding channel can be very effectively suppressed.

The sheet recognition unit 60 may include an optical line sensor (contact image sensor) 80 as shown in the views (a) and (b) of FIG. 6. The optical line sensor 80, the thickness detection sensor 70, and the magnetic line sensor 1 may be arranged in this order in the transport direction of the banknotes BN transported along the transport path 61 of the sheet recognition unit 60.

The thickness detection sensor 70 may detect the thickness of each banknote BN by detecting the amount of displacement of one of its rollers opposing each other across the transport path 61 when the banknote BN passes between the rollers.

The optical line sensor 80 may detect the optical information (image data) of each banknote BN transported along the transport path 61.

The optical line sensor 80, the thickness detection sensor 70, and the magnetic line sensor 1 are each provided linearly in the width direction of the transport path 61, and may each be sufficiently longer than the width of the transport path 61, so that the entire surface of the banknote BN can be detected.

A bristle roller 62 may be arranged opposite the magnetic line sensor 1 across the transport path 61. This allows each banknote BN to be brought into close contact with the magnetic detection surface of the magnetic line sensor 1.

The sheet recognition unit 60 may also include a transport system to enable each banknote BN to move within the transport path 61 and a photosensor that detects the arrival or passage of a banknote BN, for example.

### (Embodiment 2)

Next, a magnetic line sensor, a sheet recognition unit, and a sheet handling device according to Embodiment 2 will be described.

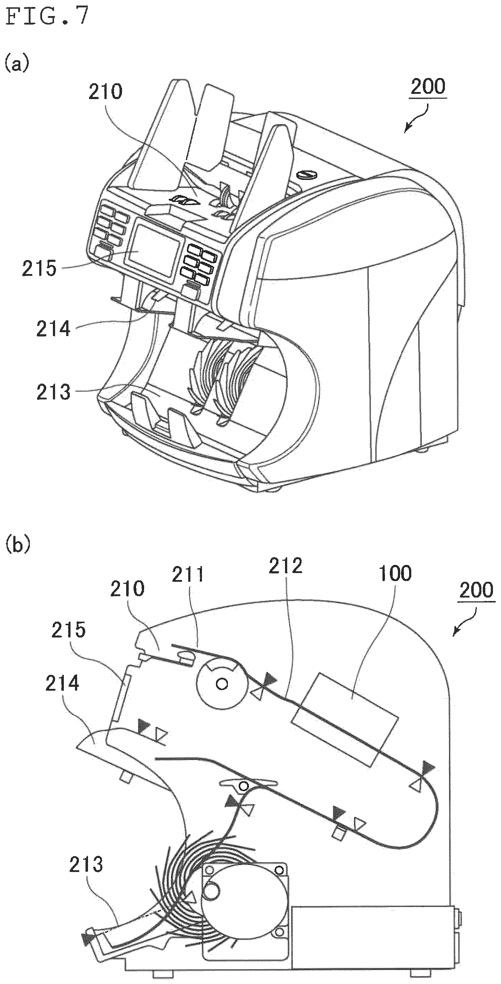

First, the configuration of the sheet handling device according to the present embodiment will be described with reference to FIG. 7. FIG. 7 includes: (a) a perspective view of the appearance of a sheet handling device according to Embodiment 2; and (b) a cross-sectional view of the internal structure of the sheet handling device according to Embodiment 2.

A sheet handling device 200 according to the present embodiment has the configuration shown in the views (a) and (b) of FIG. 7, for example. The sheet handling device 200 shown in the views (a) and (b) of FIG. 7 includes a hopper 210 in which multiple banknotes can be placed; a feeding unit 211 which feeds out banknotes placed in the hopper 210 one by one; a transport path 212 along which the banknotes fed out from the feeding unit 211 are transported; a sheet recognition unit 100 which executes banknote recognition processing; a stacking unit 213 which stacks banknotes recognized as normal by the sheet recognition unit 100; a rejecting unit 214 which stacks abnormal banknotes failing to satisfy the predetermined conditions; a display 215 which displays the information inputted to the sheet handling device 200 and the processing results, for example; and a transport unit (not shown) which transports banknotes one by one along the transport path 212. The transport unit includes a transport means such as multiple rollers and a drive device that drives the transport means, such as a motor. The sheet handling device 200 further includes transmissive or reflective optical sensors at the positions indicated by the triangles in the drawing to detect the transport conditions of the banknotes in the device. The shape and skewed state of each banknote may be presumed based on the detection results from the optical sensors. The sheet recognition unit 100, when incorporated and used in the sheet handling device 200, can successively handle the banknotes placed in the hopper 210 to sort the banknotes by returning a banknote determined as a counterfeit note, an unfit note, or a suspect note to the rejecting unit 214.

The sheet recognition unit 100 uses data (information) acquired by a variety of sensors to execute the recognition processing for banknotes BN. The contents of the recognition processing are not limited and may be, for example, in the case of a banknote, recognition of the denomination, authentication of the banknote, fitness determination, acquisition of the outline information and passage position information on the banknote, reading of the numbers, characters, and other symbols printed on the banknote, and other various functions.

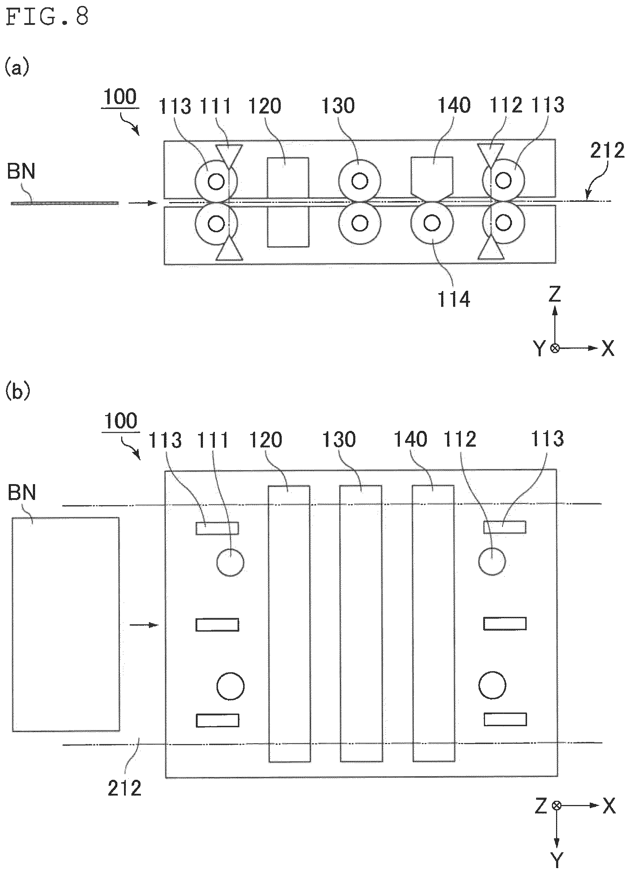

Next, the configuration of the sheet recognition unit 100 will be described with reference to FIG. 8. FIG. 8 includes: (a) a schematic cross-sectional view of the configuration of a sheet recognition unit according to Embodiment 2; and (b) a schematic plan view of the configuration of the sheet recognition unit according to Embodiment 2.

As shown in the views (a) and (b) of FIG. 8, the sheet recognition unit 100 includes an upper unit and a lower unit between which the transport path 212 is sandwiched. Along the transport path 212 are transported banknotes BN in the sheet handling device 200. The view (b) of FIG. 8 corresponds to a plan view of the upper unit of the sheet recognition unit 100 from below. The sheet recognition unit 100 has a structure including components aligned along the transport path 212, namely photosensors 11 which detect banknotes BN sequentially transported to the sheet recognition unit 100 and generate a banknote detection signal for determination of the timing for the sheet recognition unit 100 to start detection of the banknotes BN; an optical line sensor (contact image sensor) 120 which detects the optical information (image data) of each banknote BN transported along the transport path 212; a thickness detection sensor 130 which detects the thickness of each banknote BN by detecting the amount of displacement of one of its rollers opposing each other across the transport path 212 when the banknote BN passes between the rollers; a magnetic line sensor 140 which detects the magnetic information of the banknote BN transported along the transport path 212; and photosensors 112 which detect passage of the banknote BN. The optical line sensor 120, the thickness detection sensor 130, and the magnetic line sensor 140 are each arranged linearly in the width direction of the transport path 212 and are sufficiently longer than the width of the transport path 212 so that the entire surface of the banknote BN can be detected. The sheet recognition unit 100 also includes a transport system 113 to enable each banknote BN to move within the transport path 212. The transport system 113 is not limited, and may be, for example, a system that uses a drive device such as a motor to drive components such as rollers or a belt(s). In addition, below the magnetic line sensor 140 is arranged a bristle roller 114 having a bristle material on its peripheral surface, so that the banknote BN can come into close contact with the magnetism detection surface of the magnetic line sensor 140.

The magnetic line sensor 140 is arranged linearly in the width direction of the transport path 212 to face one of the surfaces of the transport path 212. The magnetic line sensor 140 detects the magnetic information such as the magnetic ink printed on a banknote BN for the entire surface of the banknote BN.

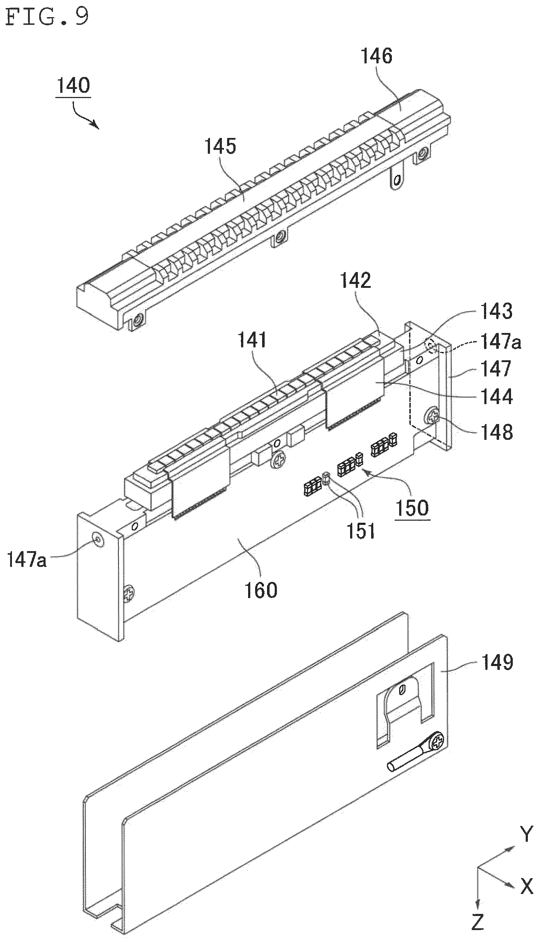

FIG. 9 is an exploded schematic perspective view of an example of the magnetic line sensor according to Embodiment 2.

The magnetic line sensor 140 is a multi-channel magnetic line sensor including, as shown in FIG. 9, multiple magnetoresistive elements (MR elements) 141 as multiple magnetic sensor elements each provided for a corresponding channel and arranged in the main scanning direction Y; a sensor substrate 142 on which the multiple magnetoresistive elements 141 are mounted; a magnet 143 to which the sensor substrate 142 is fixed and which generates a bias magnetic field; two amplifier substrates 160 on each of which multiple chip ceramic capacitors 150 are mounted; multiple flexible flat cables (FFCs) 144 each connecting the sensor substrate 142 to one of the two amplifier substrates 160; a sliding cover 146 to which a wear-resistant plate 145 is attached; a frame 147 to which the two amplifier substrates 160 are each fixed with screws 148 as fixing members and to which the magnets 143 having the sensor substrate 142 fixed thereto is fixed; and a shield plate 149 fixed to the frame 147 so as to cover these components.

The two amplifier substrates 160 are arranged on both sides of the frame 147 in the sub-scanning direction X. FIG. 9 shows only one of the amplifier substrates 160.

The sliding cover 146 is fixed to the frame 147 with screws so as to cover the magnetoresistive elements 141. Banknotes BN slide on the wear-resistant plate 145 while being held in close contact with the wear-resistant plate 145 by the bristle roller 114.

A pair of screw holes 147a in which screws are inserted are provided, one at one end of the frame 147 and the other at the other end of the frame 147 in the main scanning direction Y. The frame 147 is attached to the frame (not shown) of the main body of the sheet recognition unit 100 by a pair of screws (not shown).

Each magnetoresistive element 141 is an anisotropic magnetoresistive element (AMR element) and includes, for example, a resistance pattern exhibiting a change in resistance in response to application of a magnetic field perpendicular to the current direction and a resistance pattern exhibiting no change in resistance in response to the application. The resistance patterns are connected in series between the first and second input terminals. External voltage is applied to the first input terminal. The second input terminal is connected to ground. The connection point of these resistance patterns serves as an output terminal, from which a detection signal consisting of a voltage level is output.

Each chip ceramic capacitor 150 is a surface-mount type multilayer ceramic capacitor, and has a pair of external electrodes 151. One capacitor 150 is connected to a corresponding magnetoresistive element 141. The same number of capacitors 150 as the number of magnetoresistive elements 141 is mounted on the two amplifier substrates 160.

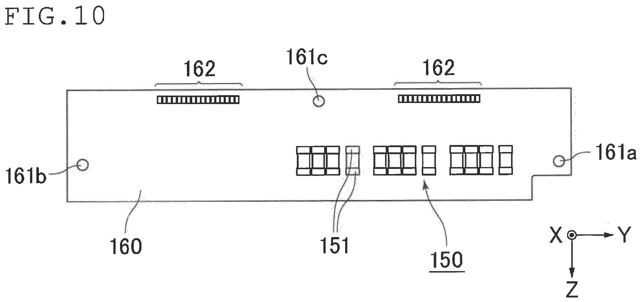

FIG. 10 is a schematic plan view of an example of an amplifier substrate according to Embodiment 2.

As shown in FIG. 10, the planar shape of each amplifier substrate 160 is rectangular, and the long and short sides thereof respectively extend in the main scanning direction Y and the height direction Z. Each amplifier substrate 160 has screw holes 161a and 161b for frame fixing as through holes in one end and the other end of the amplifier substrate 160 in the longitudinal direction of the amplifier substrate 160. Each amplifier substrate 160 also has one screw hole 161c for frame fixing as a through hole in the central part of the amplifier substrate 160 in the longitudinal direction of the amplifier substrate 160. Each amplifier substrate 160 includes multiple pads 162 for FFC 144 connection.

As shown in FIG. 10, the multiple capacitors 150 are arranged in a line parallel to the main scanning direction Y on each amplifier substrate 160 in a region closer to the screw hole 161a.

In the present embodiment, all the capacitors 150 including the capacitor closest to the screw hole 161a each have its pairs of external electrodes 151 aligned in a direction orthogonal to the main scanning direction Y. Thus, the generation of noise in output signals of each channel due to vibrations from the thickness detection sensor 130 can be suppressed.

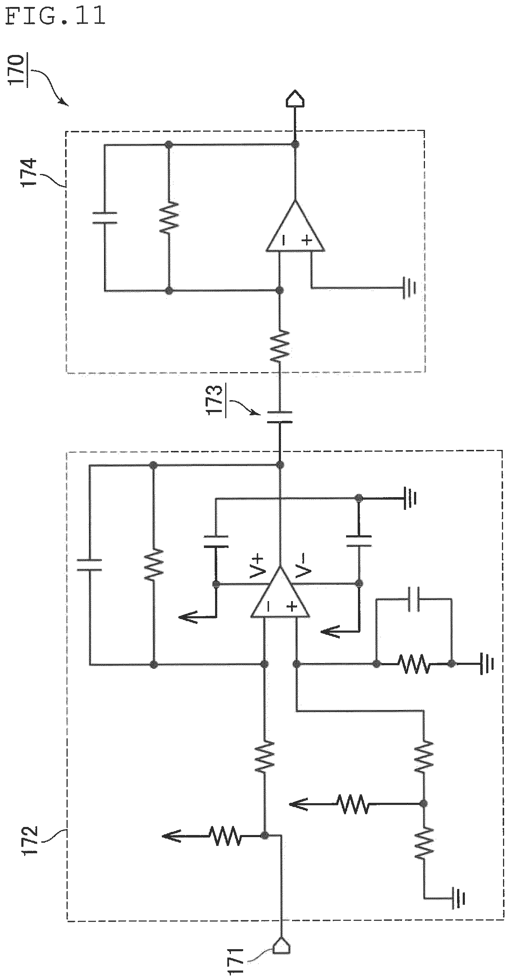

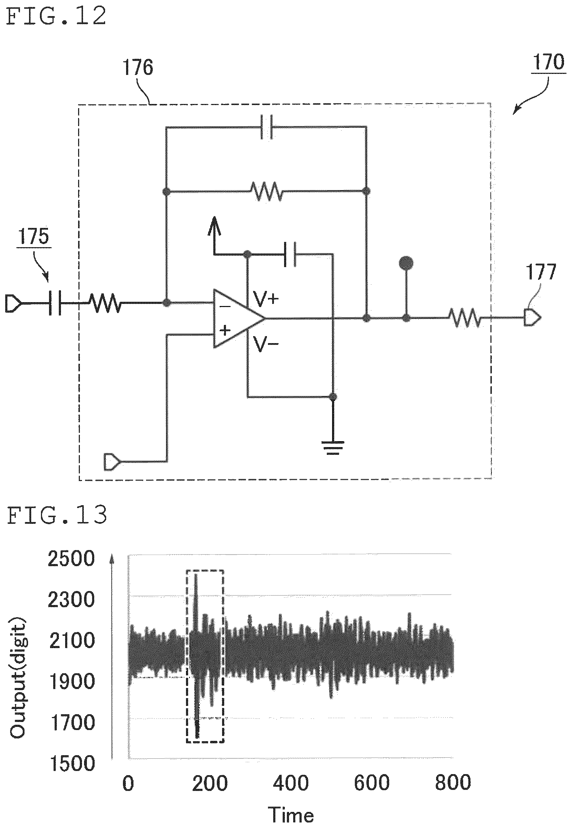

FIG. 11 and FIG. 12 are respectively circuit diagrams of the first half and the second half of an example of an electrical circuit of the amplifier substrate according to Embodiment 2.

Each amplifier substrate 160 includes a signal processing circuit 170 shown in FIG. 11 and FIG. 12 for each magnetoresistive element 141. The signal processing circuit 170 includes an input terminal 171 to which output signals of the corresponding magnetoresistive element 141 is input, a first amplifier circuit 172 connected to the input terminal 171, a second amplifier circuit 174 connected to the first amplifier circuit 172 via a high-pass filter 173, a third amplifier circuit 176 connected to the second amplifier circuit 174 via a high-pass filter 175, and an output terminal 177 connected to the third amplifier circuit 176.

Here, the high-pass filter 173 is composed of the orthogonally arranged chip ceramic capacitor 150 described above. This can more effectively reduce noise due to vibrations from the outside.

In the present embodiment, the high-pass filter 175 is also composed of the orthogonally arranged chip ceramic capacitor, but the capacitors may not be orthogonally arranged capacitors. This is because as long as the high-pass filter 173 is composed of the orthogonally arranged chip ceramic capacitor 150, the generation of noise due to vibrations from the thickness detection sensor 130 can be sufficiently suppressed.

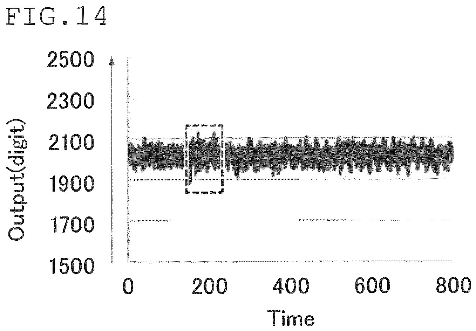

Sheet recognition units were fabricated each using a magnetic line sensor together with the thickness detection sensor, with different orientations of the chip ceramic capacitors. The output waveforms of the magnetic line sensors were measured. The results are shown in FIG. 13 and FIG. 14.

FIG. 13 shows an example of the measurement result of an output waveform of a magnetic line sensor according to Comparative Embodiment 1. FIG. 14 shows an example of the measurement result of an output waveform of the magnetic line sensor according to Embodiment 2.

The magnetic line sensor according to Comparative Embodiment 1 has a configuration similar to that of the magnetic line sensor according to Embodiment 2, except that each chip ceramic capacitor for the high-pass filter 173 has its pair of external electrodes aligned in a direction parallel to the main scanning direction.

In the magnetic line sensor according to Comparative Embodiment 1, as shown in FIG. 13, noise was generated in the output waveform when the medium entered the thickness detection sensor (the period surrounded by the dashed line in the figure).

In contrast, in the magnetic line sensor according to Embodiment 2 in which each chip ceramic capacitor for the high-pass filter 173 has its pair of external electrodes aligned in a direction orthogonal to the main scanning direction Y, as shown in FIG. 14, almost no noise was generated in the output waveform even when the medium entered the thickness detection sensor (the period surrounded by the dashed line in the figure).

As described above, in the embodiments above, at least one of the multiple chip ceramic capacitors, each electrically connected to a corresponding one of the multiple magnetic sensor elements, is arranged such that the capacitor has its pair of external electrodes aligned in a direction orthogonal to the main scanning direction of the magnetic line sensor. This can inexpensively suppress the generation of noise due to vibrations from outside the magnetic line sensor in output signals of the corresponding channel.

In the embodiments above, each banknote is subjected to long edge feed along the transport path in the sheet recognition unit and the sheet handling device. Alternatively, the banknote may be subjected to short edge feed along the transport path in the sheet recognition unit and the sheet handling device of the present disclosure.

The embodiments have been described above with reference to the drawings. The present disclosure is not limited to these embodiments. The configurations of the embodiments may be combined or modified as appropriate within the spirit of the present disclosure.

### INDUSTRIAL APPLICABILITY

As described above, the present disclosure provides a technique useful in suppressing noise due to the vibrations from outside the magnetic line sensor.

### REFERENCE SIGNS LIST

1, 140: magnetic line sensor
2: detection region
3: magnetic sensor element
10, 10a, 13, 150: chip ceramic capacitor
11, 151: pair of external electrodes
12: ceramic body
12a: first main face
12b: second main face
12c: first side face
12d: second side face
12e: first end face
12f: second end face
20: substrate
21, 147a, 161a, 161b, 161c: screw hole
31, 172: first amplifier circuit
32, 174: second amplifier circuit
33, 176: third amplifier circuit
60, 100: sheet recognition unit
61, 212: transport path
62, 114: bristle roller
70, 130: thickness detection sensor
80, 120: optical line sensor
111, 112: photosensor
113: transport system
141: magnetoresistive element
142: sensor substrate
143: magnet
144: FFC
145: wear-resistant plate
146: sliding cover
147: frame
148: screw
149: shield plate
160: amplifier substrate
162: pad
170: signal processing circuit
171: input terminal
173, 175: high-pass filter
177: output terminal
200: sheet handling device
210: hopper
211: feeding unit
213: stacking unit
214: rejecting unit
215: display
BN: banknote

## Claims

1. A magnetic line sensor that is in a multi-channel system and detects magnetic information of a transported sheet, the magnetic line sensor comprising:
multiple magnetic sensor elements each provided for a corresponding channel and arranged in a main scanning direction;
multiple chip ceramic capacitors each electrically connected to a corresponding one of the multiple magnetic sensor elements and each having a pair of external electrodes; and
a substrate on which the chip ceramic capacitors are mounted,
at least one of the chip ceramic capacitors having its pair of external electrodes aligned in a direction orthogonal to the main scanning direction.

2. The magnetic line sensor according to claim 1,
wherein a longitudinal direction of the substrate is oriented in the main scanning direction.

3. The magnetic line sensor according to claim 1 or 2, further comprising
multiple first amplifier circuits each electrically connected to a corresponding one of the multiple magnetic sensor elements and each being configured to amplify an output signal of the corresponding magnetic sensor element, and
multiple second amplifier circuits each electrically connected to a corresponding one of the multiple first amplifier circuits via corresponding one or more of the multiple chip ceramic capacitors and each being configured to amplify an output signal of the corresponding first amplifier circuit.

4. The magnetic line sensor according to any one of claims 1 to 3, further comprising a frame to which the substrate is attached with a fixing member,
wherein the substrate has a through hole in which the fixing member is inserted, and
a chip ceramic capacitor closest to the through hole among the multiple chip ceramic capacitors has its pair of external electrodes aligned in a direction orthogonal to the main scanning direction.

5. The magnetic line sensor according to any one of claims 1 to 4,
wherein all the chip ceramic capacitors have their pair of external electrodes aligned in a direction orthogonal to the main scanning direction.

6. A sheet recognition unit comprising:
the magnetic line sensor according to any one of claims 1 to 5; and
a thickness detection sensor adjacent to the magnetic line sensor.

7. A sheet handling device comprising the sheet recognition unit according to claim 6.
